(19) Europäisches Patentamt
European Patent Office
Office européen des brevets

(11) **EP 1 986 333 B1**

(12) **FASCICULE DE BREVET EUROPEEN**

(45) Date de publication et mention de la délivrance du brevet:
**10.03.2010 Bulletin 2010/10**

(51) Int Cl.:
*H04B 1/04* (2006.01)    *H03F 1/32* (2006.01)

(21) Numéro de dépôt: **08155166.5**

(22) Date de dépôt: **25.04.2008**

(54) **Linéarisation dans une chaîne d'émission**

Linearisierung einer Emissionskette

Linearisation in an emission channel

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **25.04.2007 FR 0703004**

(43) Date de publication de la demande:
**29.10.2008 Bulletin 2008/44**

(73) Titulaire: **EADS Secure Networks**
**78990 Elancourt (FR)**

(72) Inventeurs:
• **Mege, Philippe**
  **92340, Bourg la Reine (FR)**
• **Legal, Pierre-Yves**
  **78390, Bois d'Arcy (FR)**

• **Brutel, Christophe**
  **06800, Cagnes (FR)**

(74) Mandataire: **Cabinet Plasseraud**
**52, rue de la Victoire**
**75440 Paris Cedex 09 (FR)**

(56) Documents cités:
**WO-A-99/33170**

• **MATSUOKA T ET AL: "COMPENSATION OF NONLINEAR DISTORTION DURING TRANSMISSION BASED ON THE ADAPTIVE PREDISTORTION METHOD" IEICE TRANSACTIONS ON ELECTRONICS, ELECTRONICS SOCIETY, TOKYO, JP, vol. E80-C, no. 6, juin 1997 (1997-06), pages 782-787, XP000740549 ISSN: 0916-8524**

**Description**

La présente invention se rapporte à une chaîne d'émission pour transmission radio comprenant un amplificateur de puissance qui introduit une distorsion sur le signal à traiter par cette chaîne d'émission.

Les systèmes de transmission radio qui comprennent une chaîne d'émission ayant un amplificateur de puissance présentent une distorsion au regard de la linéarité du signal dans la plage de fonctionnement de l'amplificateur de puissance. En outre, afin d'augmenter le rendement de l'amplificateur de puissance, il est classiquement prévu de l'utiliser dans une zone de sa plage de fonctionnement qui est proche d'une zone de saturation. Or, cette distorsion est d'autant plus importante dans une telle zone de fonctionnement.

Une telle distorsion dégrade le spectre fréquentiel du signal émis et de ce fait peut perturber la transmission dans des canaux adjacents ('ACPR', pour 'Adjacent Channel Power Ratio' en anglais).

Pour éviter cette distorsion, on peut prévoir d'éloigner le point de fonctionnement de la zone de saturation de l'amplificateur de puissance. Toutefois, dans ce cas, le rendement de ce dernier s'en trouve diminué. De ce fait, la consommation de la chaîne d'émission augmente et son autonomie en énergie s'en trouve restreinte.

On peut aussi prévoir d'utiliser une méthode de linéarisation consistant à appliquer une pré-distorsion du signal modulé avant de le fournir à l'amplificateur de puissance, la pré-distorsion permettant alors d'obtenir en sortie de l'amplificateur de puissance le signal que l'on souhaite transmettre corrigé des effets de distorsion, notamment des distorsions de l'amplitude de sortie en fonction de l'amplitude du signal d'entrée et des distorsions de la phase du signal de sortie en fonction de l'amplitude du signal d'entrée.

De telles méthodes de linéarisation sont basées sur la détermination d'une pluralité de paramètres destinés à permettre de déterminer la pré-distorsion qu'il convient d'appliquer au signal à fournir à l'amplificateur de puissance. Une telle détermination est en règle générale complexe. Par ailleurs, classiquement, ces méthodes de linéarisation sont basées sur une phase d'initialisation ou encore de calibration au cours de laquelle des coefficients de pré-distorsion initiaux sont déterminés. Puis, par une rétro action, on détermine les coefficients de pré-distorsion de manière évolutive de sorte à ajuster leurs valeurs respectives en fonction de modifications qui peuvent intervenir au cours du temps.

Ainsi, ces méthodes présentent l'inconvénient de gérer des coefficients de pré-distorsion qui sont complexes à déterminer, leur détermination requérant une phase de calibration préalable.

La présente invention vise à améliorer la situation.

Un premier aspect de la présente invention propose un procédé de traitement d'un signal dans une chaîne d'émission comprenant :

- un amplificateur de puissance adapté pour recevoir en entrée un signal à amplifier et pour fournir en sortie un signal amplifié ;
- un module de pré-distorsion comprenant, d'une part, une unité de linéarisation adaptée pour appliquer un coefficient de pré-distorsion à un signal d'entrée, et, d'autre part, une unité de détermination dudit coefficient de pré-distorsion ;

ledit procédé de traitement comprenant les étapes suivantes au niveau du module de pré-distorsion :

/a/ au niveau de l'unité de détermination de coefficient de pré-distorsion, recevoir, d'une part, le signal d'entrée et, d'autre part, le signal amplifié à travers une voie de retour, et déterminer le coefficient de pré-distorsion à partir d'une comparaison entre le signal d'entrée et le signal amplifié observé à travers la voie de retour;

/b/ au niveau de l'unité de linéarisation, appliquer le coefficient de pré-distorsion au signal d'entrée pour fournir en sortie le signal à amplifier ;

dans lequel le coefficient de pré-distorsion est déterminé, au niveau de l'unité de détermination, sur la base d'une approximation au premier ordre du signal d'entrée.

En procédant ainsi, il est alors possible de déterminer de manière simple et toutefois fiable un coefficient de pré-distorsion de sorte à réduire, voir annuler la distorsion qui peut être générée au niveau de l'amplificateur de puissance. La présente invention est plus particulièrement applicable à des signaux à transmettre possédant une composante de modulation d'amplitude mais pour lesquels la variation d'amplitude reste limitée. Du fait de la limitation de cette variation d'amplitude, l'approximation au premier ordre présentée dans la suite peut être appliquée.

Dans un mode de réalisation de la présente invention, le signal d'entrée vérifie l'équation suivante selon l'approximation au premier ordre :

$$S(t) = A.(1 + a(t)).e^{j.\varphi(t)},$$

où A représente l'amplitude moyenne du signal, a(t) représente la variation relative d'amplitude du signal, j représente la racine carrée de -1 ; et φ(t) la phase du signal ; et dans lequel le coefficient de pré-distorsion W(t) vérifie l'équation suivante :

$$W(t) = C(t) + E(t).a(t)$$

où C(t) et E(t) correspondent respectivement à des premier et second paramètres de pré-distorsion qui sont des fonctions complexes du temps.

Dans une réalisation particulière de la présente invention, on peut avantageusement fixer un des paramètres de pré-distorsion, le paramètre C(t), à la valeur 1.

La puissance du signal de sortie peut-être affectée par le fait que ce signal de sortie est introduit dans la voie de retour par couplage. En fixant ainsi la valeur du paramètre C(t) à 1, il est alors possible de s'affranchir de ce problème. En outre, dans ce mode de réalisation, seul le paramètre de pré-distorsion E(t) reste à déterminer, ce qui contribue à simplifier la mise en oeuvre d'un tel procédé.

On peut avantageusement prévoir de déterminer au moins un parmi les premier et second paramètres de pré-distorsion en appliquant un algorithme de gradient stochastique.

Le paramètre de pré-distorsion E(t) peut vérifier l'équation suivante :

$$E(t+1) = E(t) + \mu_e.e(t+1).\left(\frac{D_w(t+1)}{W(t)}\right)^* .a(t+1)$$

où $D_w(t+1)$ correspond au signal amplifié par l'amplificateur de puissance ;
où

$$e(t+1) = S(t+1) - D_w(t+1) \; ;$$

où $\mu_e$ est le pas du gradient pour le paramètre de pré-distorsion E(t) ; et le coefficient de pré-distorsion vérifie l'équation suivante :

$$W(t+1) = C(t) + E(t).a(t+1)$$

En outre, s'il n'est pas forcé à la valeur 1, le paramètre de pré-distorsion C(t) peut vérifier l'équation suivante :

$$C(t+1) = C(t) + \mu_c.e(t+1).\left(\frac{D_w(t+1)}{W(t)}\right)^*$$

où $D_w(t+1)$ correspond au signal amplifié en sortie de l'amplificateur de puissance ;
où $\mu_c$ est le pas du gradient pour le paramètre de pré-distorsion C(t) ; et
où W(t) correspond au coefficient de pré-distorsion.

Dans un mode de réalisation de la présente invention, le signal à amplifier est organisé sous forme de trame et le coefficient de pré-distorsion est mis à jour toutes les N trame(s), N étant un entier supérieur ou égal à 1.

Ainsi, la mise en oeuvre d'un tel procédé peut être simplifiée par rapport à un mode de réalisation au cours duquel la détermination du coefficient de pré-distorsion est effectuée de manière continue.

On peut également prévoir que, la mise en oeuvre d'un tel procédé soit précédée d'une phase d'initialisation au cours de laquelle au moins un coefficient de pré-distorsion initial est déterminé. Dans ce cas, on peut se baser sur des mesures préalablement établies pour déterminer ce coefficient de pré-distorsion initial, ces mesures étant réalisées de manière indépendante au traitement adaptatif appliqué ensuite au signal à transmettre.

Dans le cas où l'on considère que le signal d'entrée et le signal amplifié sont décalés d'un retard T, Procédé de traitement selon la revendication 4 ou 5, dans lequel, le signal d'entrée S(t) (14) et le signal amplifié $D_w(t)$ (16) étant décalés d'un retard T, le paramètre de pré-distorsion E(t) vérifie l'équation suivante :

$$E(t+1) = E(t) + \mu_e.e(t+1).\left( \frac{D_w(t+1)}{W(t)} \right)^{\cdot}.a(t+1)$$

où $D_w(t+1)$ correspond au signal amplifié par l'amplificateur de puissance et reçu au niveau de l'unité de détermination via la voie de retour ;
où

$$e(t+1) = S(t+1-\tau) - \dot{D}_w(t+1) ;$$

où $\mu_e$ est le pas du gradient pour le paramètre de pré-distorsion E(t) ; et le coefficient de pré-distorsion vérifie l'équation suivante :

$$W(t+1) = C(t) + E(t).a(t+1)$$

On peut aussi prévoir que le signal d'entrée S(t) est décomposé en une pluralité de portions de signal d'entrée, chaque portion de signal d'entrée appartenant à différentes plages d'amplitudes. On peut alors obtenir une pluralité de coefficients de pré-distorsion $W_i(t)$, pour i allant de 1 à N, N étant un entier strictement supérieur à 1, respectivement pour la pluralité de portions de signal d'entrée, par application des étapes /a/ et /b/ à chacune desdites portions de signal d'entrée, sur la base d'une approximation au premier ordre de ladite portion de signal d'entrée.

Grâce à ces dispositions, l'application d'un tel procédé à un signal d'entrée présentant de plus grandes variations d'amplitude peut être avantageuse.

Un second aspect de la présente invention propose une chaîne d'émission d'un signal comprenant :

- un amplificateur de puissance adapté pour recevoir en entrée un signal à amplifier et pour fournir en sortie un signal amplifié ;
- un module de pré-distorsion comprenant, d'une part, une unité de linéarisation adaptée pour appliquer un coefficient de pré-distorsion à un signal d'entrée, et, d'autre part, une unité de détermination dudit coefficient de pré-distorsion ;

dans laquelle l'unité de détermination de coefficient de pré-distorsion est adaptée pour recevoir, d'une part, le signal d'entrée et, d'autre part, le signal amplifié, et pour déterminer le coefficient de pré-distorsion à partir d'une comparaison entre le signal d'entrée et le signal amplifié sur la base d'une approximation au premier ordre du signal d'entrée ; et, dans laquelle l'unité de linéarisation est adaptée pour recevoir le signal d'entrée, et appliquer le coefficient de pré-distorsion pour fournir en sortie le signal à amplifier.

Cette chaîne d'émission peut également comprendre des moyens adaptés pour mettre en oeuvre un procédé de traitement d'un signal selon le premier aspect de la présente invention.

D'autres aspects, buts et avantages de l'invention apparaîtront à la lecture de la description d'un de ses modes de réalisation.

L'invention sera également mieux comprise à l'aide des dessins, sur lesquels :

- la figure 1 illustre une partie d'une chaîne d'émission de signal radio selon un mode de réalisation de la présente invention ;
- la figure 2 illustre une partie d'une chaîne d'émission de signal radio induisant un retard selon un mode de réalisation de la présente invention ;
- la figure 3 illustre une application d'un traitement de signal selon un mode de réalisation de la présente invention dans lequel le signal d'entrée présente des variations relativement importantes.

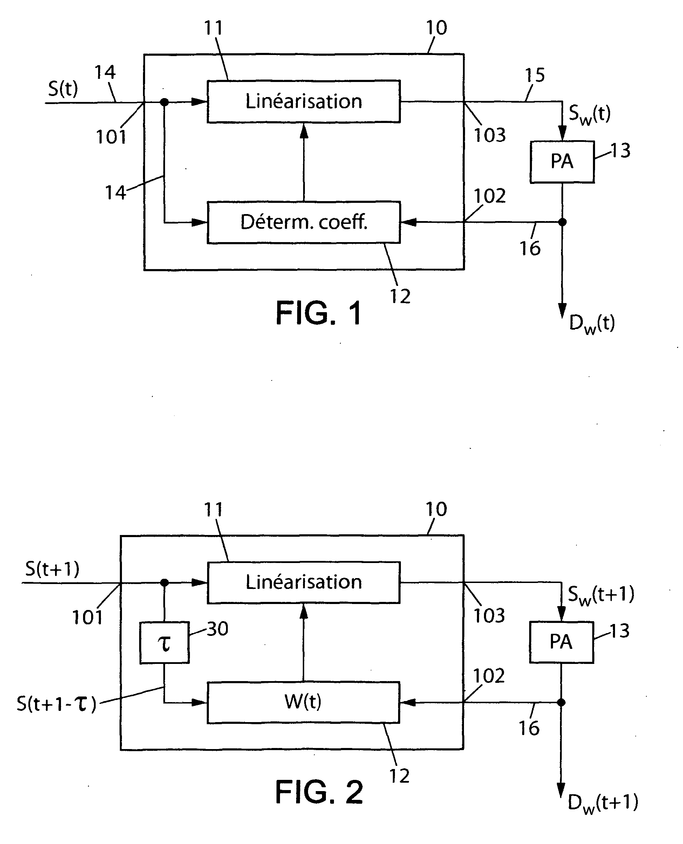

La figure 1 illustre une partie d'une chaîne d'émission de signal radio dans un mode de réalisation de la présente invention.

Cette partie de la chaîne d'émission comprend un module de pré-distorsion 10 et un amplificateur de puissance 13. Le module de pré-distorsion 10 présente une première entrée 101 adaptée pour recevoir un signal d'entrée 14 et une sortie 103 pour fournir à l'amplificateur de puissance 13 un signal à amplifier 15. Ainsi, le module de pré-distorsion 10 a en charge la transformation d'un signal d'entrée 14 en un signal de sortie qui est le signal à amplifier 15.

Ce module de pré-distorsion 10 comprend en outre une liaison de retour 16 par laquelle le signal amplifié est injecté en rétroaction via une entrée 102 du module 10.

Il comprend en outre une unité de linéarisation 11 qui est en charge d'appliquer un ou plusieurs coefficients de pré-distorsion au signal d'entrée 14 afin d'obtenir un signal à amplifier, l'application de coefficient de pré-distorsion étant destinée à contrebalancer la distorsion qui découle de l'amplification de signal mise en oeuvre par l'amplificateur de puissance, de telle sorte que cette distorsion s'en trouve réduite, voire même annulée.

Il comprend aussi une unité de détermination de coefficient de pré-distorsion 12 qui est adaptée pour recevoir, d'une part, le signal d'entrée 14 et, d'autre part, le signal amplifié 16 fourni par l'amplificateur de puissance 13 et qui est injecté en rétroaction dans le module de pré-distorsion 10. Puis, sur la base d'une comparaison de ces deux signaux reçus, l'unité de détermination 12 est en charge de déterminer le ou les coefficients de pré-distorsion à appliquer au signal d'entrée au niveau de l'unité de linéarisation 11. Elle est ensuite en mesure de fournir le coefficient de pré-distorsion à l'unité de linéarisation 11 qui peut alors l'appliquer au signal d'entrée.

Par la suite, on note :

- S(t) le signal d'entrée 14 que l'on souhaite transmettre via une transmission radio en sortie de la chaîne d'émission et qui est fourni en sortie d'un modulateur au module de pré-distorsion 10 selon un mode de réalisation de la présente invention ;
- $S_w(t)$ le signal de sortie 15 du module de pré-distorsion, c'est-à-dire le signal d'entrée de l'amplificateur de puissance ;
- $D_w(t)$ le signal de sortie de l'amplificateur de puissance qui correspond également au signal de rétro action 16 entrant dans le module de pré-distorsion ; et
- W(t) la pré-distorsion à appliquer au signal au niveau du module de pré-distorsion 10.

Par la suite, si X est un nombre complexe, Re(X) désigne la partie réelle de ce nombre complexe et Im(X) désigne la partie imaginaire de ce nombre complexe. X* est le nombre conjugué du nombre complexe X.

En outre, pour X une variable complexe, et f(X) une fonction de cette variable complexe, on note :

$$\left(\frac{df(X)}{dX}\right)_{complexe} = \left(\frac{df(X)}{d\,\mathrm{Re}(X)}\right)_{réel} + j\cdot\left(\frac{df(X)}{d\,\mathrm{Im}(X)}\right)_{réel}$$

où « complexe » et « réel » indiqués en indice des dérivées précisent respectivement des dérivées au sens de la dérivation par rapport à une variable complexe et par rapport à une variable réelle.

Il en découle que :

si Y est une variable réelle et g(Y) est une fonction de cette variable réelle, on peut écrire l'équation suivante :

$$\left(\frac{dg(Y)}{dY}\right)_{réel} = \frac{1}{2}\cdot\left[\left(\frac{dg(Y)}{dY}\right)_{complexe} + \left(\frac{dg(Y)}{dY^{*}}\right)_{complexe}\right]$$

De plus, si g(Y) est une fonction à valeurs réelles, l'équation suivante est vérifiée :

$$\left(\frac{dg(Y)}{dY}\right)_{réel} = \mathrm{Re}\left[\left(\frac{dg(Y)}{dY}\right)_{complexe}\right]$$

En outre, si X est un nombre complexe :

$$\left(\frac{dX}{dX}\right)_{complexe} = 0$$

et

$$\left(\frac{dX}{dX^\bullet}\right)_{complexe} = 2$$

Par ailleurs si f(X) est une fonction de la variable complexe X, on peut écrire :

$$\left(\frac{d\left(\|f(X)\|^2\right)}{dX}\right)_{complexe} = 2.f(X).\left(\frac{df^\bullet(X)}{dX}\right)_{complexe}$$

On a également, si X est une variable complexe et si f(X) et g(X) sont des fonctions de cette variable complexe, une règle de changement de variable qui vérifie l'équation suivante :

$$\left(\frac{dg(X)}{d(X)}\right)_{complexe} = \frac{1}{2}\left(\frac{dg(X)}{df(X)}\right)_{complexe} . \left(\frac{df^\bullet(X)}{dX}\right)_{complexe}$$

Les autres règles applicables à la dérivation par rapport à une variable complexe découlent de celles de la dérivation classique par rapport à une variable réelle.

Par la suite, par défaut dans le cas où les indices 'complexe' et 'réel' ne sont pas utilisés, la dérivation par rapport à un nombre réel correspond à une dérivation au sens des réels, et, la dérivation par rapport à un nombre complexe correspond à la dérivation au sens des complexes.

Un procédé de traitement de signal selon un mode de réalisation de la présente invention est particulièrement adapté à une modulation comportant une composante de modulation en amplitude dont les variations d'amplitude sont relativement limitées.

Ce procédé de traitement permet de simplifier la détermination de la pré-distorsion à appliquer en traitant le signal d'entrée sous la forme d'une approximation selon le premier ordre. On peut ainsi obtenir un procédé de traitement fiable, précis et adaptatif sans avoir recours à une phase de calibration préalable, comme dans l'art antérieur, tout en mettant en oeuvre des méthodes de détermination simple de la pré-distorsion. Ainsi, on peut faire l'approximation du premier ordre suivante :

$$A(t) = \|S(t)\| = A.(1 + a(t)),$$

avec a(t) petit devant 1 et A une constante.

Selon cet aspect, la pré-distorsion W(t) à appliquer au signal avant son amplification par l'amplificateur de puissance peut s'exprimer sous la forme suivante :

$$W(t) = C(t) + E(t).a(t),$$

où C(t) et E(t) sont des paramètres de pré-distorsion du coefficient de pré-distorsion.

Ces paramètres peuvent varier seulement lentement dans le temps avec t pour suivre les variations à moyen et/ou long terme de l'amplificateur de puissance. En effet, on peut adapter le comportement temps réel du module de pré-distorison en adaptant la fréquence de mise à jour des paramètres de pré-distorsion.

Une telle approximation peut être justifiée sur la base du fait que l'on suppose que l'amplificateur de puissance lui-même provoque les distorsions sur le signal à émettre, ou tout au moins provoque les disorsions les plus importantes.

On exprime le signal S(t) en sortie du modulateur sous la forme :

$$S(t) = A.(1 + a(t)).e^{j.\varphi(t)},$$

avec j représentant la racine carrée de -1 ; et $\varphi(t)$ la phase du signal.

La sortie de l'amplificateur de puissance peut alors s'écrire sous la forme :

$$D_W(t) = B.(1 + a_1.a(t)).e^{j[\varphi(t)+k.a(t)+\varphi_0]}$$

où $a_1$ représente la distorsion AM/AM, c'est-à-dire la distorsion de l'amplitude de sortie de l'amplificateur de puissance due à la variation de l'amplitude du signal d'entrée,

où $k$ représente la distorsion AM/PM de l'amplificateur de puissance, c'est-à-dire la distorsion de la phase de sortie de l'amplificateur de puissance due à la variation de l'amplitude du signal d'entrée ;

où B est une constante ; et

où $\varphi_0$ est une constante.

Les distorsions AM/AM et AM/PM sont les composantes principales des distorsions générées par les amplificateurs de puissance.

Par la suite, on note $W_{opt}(t)$ le coefficient de pré-distorsion optimal, c'est-à-dire le coefficient de pré-distorsion qui permet de compenser de façon optimale la distorsion introduite par l'amplificateur de puissance. Ce coefficient de pré-distorsion optimal vérifie l'équation suivante :

$$W_{opt}(t) = A_W(t).e^{j.\varphi_W(t)}$$

où $A_W$ est une amplitude et $\varphi_W$ est une phase.

Le signal $S_{W_{opt}}$ obtenu après l'application au signal S(t) entrant dans le module de pré-distorsion, du coefficient de pré-distorsion optimal vérifie alors l'équation suivante :

$$S_{W_{opt}}(t) = W_{opt}(t).S(t) = A_W(t).A.(1 + a(t)).e^{j.(\varphi_W(t)+\varphi(t))}$$

Dans ces conditions, le signal de sortie de l'amplificateur de puissance correspondant, noté $D_{W_{opt}}(t)$ vérifie l'équation suivante :

$$D_{W_{opt}}(t) = B.(1 + a_1.(A_W(t).(1 + a(t)) - 1)).$$

$$e^{j[\varphi_W(t)+\varphi(t)+k.(A_W(t).(1+a(t))-1)+\varphi_0+\varphi_R]}$$

où $W_{opt}(t)$ est le coefficient de pré-distorsion optimal.

Dans ce contexte, étant donné que par hypothèse le coefficient de pré-distorsion optimal compense la distorsion du signal introduite par l'amplificateur de puissance, le signal de sortie de l'amplificateur de puissance $D_{W_{opt}}(t)$ doit donc alors être égal au signal d'origine $S(t)$.

L'équation suivante est donc vérifiée :

$$A.(1+a(t)) = B.(1+a_{1}.(A_{W}(t).(1+a(t))-1))$$

On peut alors écrire :

$$A_{W}(t) = \frac{\left[\dfrac{\left(\dfrac{A.(1+a(t))}{B} - 1\right)}{a_{1}} + 1\right]}{(1+a(t))}$$

On en déduit l'équation suivante par l'application d'un développement au premier ordre en fonction de a(t) :

$$A_{W}(t) = \left(\frac{A}{B.a_{1}} + \frac{a_{1}-1}{a_{1}}\right) + a(t).\frac{(1-a_{1})}{a_{1}}$$

De même, les phases respectives du signal d'entrée et du signal de sortie de l'amplificateur de puissance sont égales et, de ce fait, l'équation suivante est donc vérifiée :

$$\varphi_{W}(t) = -[k.(A_{W}(t).(1+a(t))-1) + \varphi_{0} + \varphi_{R}] = -[k\left(\frac{1-B}{B.a_{1}} + \frac{a(t)}{B.a_{1}}\right) + \varphi_{0} + \varphi_{R}]$$

On peut donc alors écrire le coefficient de pré-distorsion optimal sous la forme suivante :

$$W_{opt}(t) = \left[\left(\frac{A}{B.a_{1}} + \frac{a_{1}-1}{a_{1}}\right) + a(t).\frac{(1-a_{1})}{a_{1}}\right].e^{-j.[k\left(\frac{1-B}{B.a_{1}} + \frac{a(t)}{B.a_{1}}\right) + \varphi_{0}]}$$

Par application d'un développement au premier ordre en fonction de a(t), on obtient alors :

$$W_{opt}(t) = \left(\frac{A}{B.a_{1}} + \frac{a_{1}-1}{a_{1}}\right).e^{-j.[k\left(\frac{1-B}{B.a_{1}}\right) + \varphi_{0}]} +$$

$$a(t).\left[\frac{(1-a_{1})}{a_{1}} - j.\left(\frac{1}{B.a_{1}} + \frac{a_{1}-1}{a_{1}}\right).\frac{k}{B.a_{1}}\right].e^{-j.[k\left(\frac{1-B}{B.a_{1}}\right) + \varphi_{0}]}$$

On peut donc exprimer $W_{opt}$ au premier ordre sous la forme comme énoncé ci-avant:

$$W(t) = C(t) + E(t).a(t)$$

C(t) et E(t) étant des complexes.

Il convient de noter que les valeurs de C(t) et de E(t) peuvent être obtenues par diverses méthodes, notamment par la mise en oeuvre d'un algorithme itératif.

Dans un mode de réalisation de la présente invention, un algorithme du gradient stochastique est mis en oeuvre pour déterminer les valeurs de ces paramètres de pré-distorsion C(t) et E(t). Ainsi, on est en mesure d'éviter la complexité liée à une résolution directe, et il est alors possible d'adapter de manière continue ces paramètres en fonction de l'évolution dans le temps des caractéristiques de l'amplificateur de puissance.

Dans ce mode de réalisation, on peut notamment chercher à réduire l'erreur quadratique suivante :

$$ e^2 = \left\| e(t+1) \right\|^2 = \left\| S(t+1) - D_w(t+1) \right\|^2 $$

Afin d'obtenir les expressions respectives des paramètres de pré-distorsion *C(t)* et de *E(t)* , on peut déterminer les valeurs de la dérivée complexe du signal de sortie de l'amplificateur de puissance par rapport au paramètre C(t),

dérivée notée $\dfrac{\partial D_w^{\cdot}(t+1)}{\partial C(t)}$ , et de la dérivée complexe du signal de sortie par rapport au paramètre E(t), dérivée notée

$$ \frac{\partial D_w^{\cdot}(t+1)}{\partial E(t)} \; . $$

On peut alors écrire l'équation suivante :

$$ \frac{\partial D_w^{\cdot}(t+1)}{\partial C(t)} = \frac{\partial D_w^{\cdot}(t+1)}{\partial S_w^{\cdot}(t+1)} \cdot \frac{\partial S_w^{\cdot}(t+1)}{\partial C(t)} = \frac{\partial D_w^{\cdot}(t+1)}{\partial S_w^{\cdot}(t+1)} . S(t+1)^{\cdot} $$

où $\dfrac{\partial D_w^{\cdot}(t+1)}{\partial S_{w}^{\cdot}(t+1)}$ est la dérivée complexe du signal de sortie de l'amplificateur de puissance par rapport au signal $S_w$

(t) correspondant au signal d'entrée S(t) auquel on a appliqué le coefficient de pré-distorsion.

Cette dérivée complexe du signal de sortie de l'amplificateur de puissance par rapport au signal $S_w$(t) peut être calculée ou estimée de différentes manières.

Dans un mode de réalisation de la présente invention, on prévoit d'effectuer une approximation de cette dérivée par le rapport du signal de sortie sur le signal d'entrée de l'amplificateur de puissance. Cette approximation permet une réalisation simple et une mise en oeuvre aisée de l'algorithme itératif du gradient stochastique.

Dans le contexte d'une telle approximation, on peut écrire l'équation suivante :

$$ \frac{\partial D_w^{\cdot}(t+1)}{\partial S_w(t+1)} \approx \frac{D_w^{\cdot}(t+1)}{S_w^{\cdot}(t+1)} \qquad\qquad [1] $$

Puis, on en déduit :

$$ \frac{\partial D_w^{\cdot}(t+1)}{\partial C(t)} \approx \frac{D_w^{\cdot}(t+1)}{S_w^{\cdot}(t+1)} . S(t+1)^{\cdot} \approx \frac{D_w^{\cdot}(t+1)}{W^{\cdot}(t)} $$

On en déduit également :

$$\frac{\partial D_w^{\cdot}(t+1)}{\partial E(t)} = \frac{\partial D_w^{\cdot}(t+1)}{\partial S_w(t+1)} \cdot \frac{\partial S_w^{\cdot}(t+1)}{\partial E(t)} = \frac{\partial D_w^{\cdot}(t+1)}{\partial S_w(t+1)} \cdot a(t+1).S(t+1)^{\cdot}$$

En utilisant, dans la réalisation préférée, l'approximation énoncée à l'équation [1] pour la dérivée, on peut écrire :

$$\frac{\partial D_w^{\cdot}(t+1)}{\partial E(t)} \approx \frac{D_w^{\cdot}(t+1)}{S_w^{\cdot}(t+1)}.a(t+1).S(t+1)^{\cdot} = \frac{D_w^{\cdot}(t+1)}{W^{\cdot}(t)}.a(t+1)$$

Les expressions du gradient stochastique appliqué aux paramètres de pré-distorsion deviennent donc, dans un mode de réalisation de la présente invention :

$$C(t+1) = C(t) + \mu_c.e(t+1).\left(\frac{D_w(t+1)}{W(t)}\right)^{\cdot}$$

$$E(t+1) = E(t) + \mu_e.e(t+1).\left(\frac{D_w(t+1)}{W(t)}\right)^{\cdot}.a(t+1)$$

$$W(t+1) = C(t) + E(t).a(t+1)$$

où

$$e(t+1) = S(t+1) - D_w(t+1)$$

où $\mu_c$ et $\mu_e$ sont des pas du gradient respectivement pour les paramètres C(t) et E(t).

Dans un mode de réalisation, il est considéré que l'amplificateur de puissance et les autres éléments de la chaîne émission induisent un retard T par rapport au signal d'origine, ce retard étant supposé connu. Le signal de référence, S(t+1), est donc retardé de ce retard T.

Plus précisément, dans le schéma ci-dessus, l'erreur quadratique que l'on cherche à minimiser, ou réduire, vérifie l'équation suivante :

$$e^2 = \left\|e(t+1)\right\|^2 = \left\|S(t+1-\tau) - D_w(t+1)\right\|^2$$

Les expressions du gradient stochastique deviennent donc, dans un mode de réalisation de la présente invention :

$$C(t+1) = C(t) + \mu_c.e(t+1).\left(\frac{D_w(t+1)}{W(t)}\right)^{\cdot}$$

$$E(t+1) = E(t) + \mu_e \cdot e(t+1) \cdot \left( \frac{D_w(t+1)}{W(t)} \right)^{\cdot} \cdot a(t+1)$$

$$W(t+1) \doteq C(t) + E(t) \cdot a(t+1)$$

où

$$e(t+1) = S(t+1-\tau) - D_w(t+1)$$

Par ailleurs, la puissance du signal de sortie peut-être affectée par le fait que ce signal de sortie est introduit dans la voie de retour par couplage, et il est difficile de maîtriser précisément le gain relatif à ce couplage. La puissance émise peut donc en être affectée.

On peut prévoir de s'affranchir de ce problème en normalisant le signal qui est observé sur la voie de retour avant d'effectuer la comparaison entre ce signal et le signal de référence, qui est lui-même normalisé.

Dans ce cas, pour éviter une indétermination de la puissance réellement émise, on peut par exemple forcer la valeur du paramètre de pré-distorsion C(t) à la valeur 1, et ainsi la valeur de puissance moyenne du signal pré-distordu envoyé vers l'amplificateur de puissance est maintenue à une valeur de puissance quasiment unitaire. Dans cette variante, le paramètre C(t) reste donc à une valeur égale à 1, et, de ce fait, seul E(t) est calculé, comme détaillé précédemment.

Dans un mode de réalisation de la présente invention, on peut également chercher à s'affranchir d'une erreur de phase absolue sur le signal radio transmis.

La phase absolue du signal transmis n'a d'influence ni sur les caractéristiques du signal transmis, ni sur les performances du démodulateur du récepteur. En effet, soit le récepteur est de type non-cohérent et, de ce fait, n'est pas influencé par la phase absolue du signal, soit le récepteur est de type cohérent et, dans ce cas, il commence le traitement du signal reçu par une estimation du canal et donc une estimation de la phase du signal, incluant la phase absolue du signal émis, avant de démoduler ce signal reçu.

En outre, une estimation et une correction de cette phase absolue à l'émission ajouterait une complexité inutile à la chaîne d'émission.

Par conséquent, pour s'affranchir de cette phase absolue à l'émission, il est possible d'estimer la phase de la corrélation entre le signal provenant de la voie de retour et le signal de référence et de corriger le signal reçu sur la voie de retour de cette phase estimée. La corrélation entre le signal de la voie de retour et le signal de référence peut être effectuée par exemple sur une fenêtre glissante ou encore, en particulier dans le cas de la mise en oeuvre de la variante décrite ci-dessous, elle peut être effectuée sur chaque trame.

Ce mode de réalisation est particulièrement efficace en combinaison avec la mise en oeuvre du mode de réalisation dans lequel le paramètre C(t) est maintenu égal à 1 comme décrit ci-avant.

Dans une variante, on peut mettre à jour de façon continue C(t) et E(t), ou bien encore seulement E(t) dans le cas où C(t) est maintenu égal à 1, tout en ne mettant à jour le coefficient de pré-distorsion W(t) appliqué au signal en sortie du modulateur que de temps en temps, par exemple toutes les trames si la transmission est organisée en trame. Ainsi, on peut prévoir de mettre à jour le coefficient de pré-distorsion W(t) uniquement toutes les trames par exemple. Le même coefficient de pré-distorsion est alors appliqué sur la durée de toute une trame.

Une telle variante permet de réduire les contraintes d'implémentation temps réel de la méthode de linéarisation de l'amplificateur de puissance selon un mode de réalisation de la présente invention. Il convient de noter que, dans ce cas, la première trame, ou le début du signal transmis, n'est pas pré-distordu.

Dans un mode de réalisation de la présente invention, afin de réduire le retard d'application de la pré-distorsion, il est possible d'appliquer une pré-caractérisation au signal modulé à émettre avant d'appliquer la pré-distorsion comme décrite précédemment. Cette pré-caractérisation correspond à une phase d'initialisation, ou encore de calibration, au cours de laquelle des coefficients de pré-distorsion initiaux sont déterminés.

Elle consiste à compenser les distorsions de l'amplificateur de puissance à partir de mesures faites préalablement sur l'équipement comprenant une chaine d'émission selon un mode de réalisation de la présente invention, par exemple au moment de sa fabrication, ou bien au moment où des tests de l'équipement sont effectués, ou encore à partir d'une moyenne de mesures effectuées sur des équipements d'un même type.

Une telle pré-caractérisation permet de corriger une partie des distorsions de l'amplificateur de puissance, tandis que la pré-distorsion permet d'améliorer la correction de ces distorsions et de suivre leur évolution au cours du temps car ces distorsions varient en fonction de divers paramètres comme la température, la tension d'alimentation, le taux d'onde stationnaire, le vieillissement de l'amplificateur de puissance, etc...

La mise en oeuvre d'une pré-caractérisation permet de réduire les dégradations du spectre au début de la transmission, elle permet également d'accélérer la convergence d'un algorithme itératif en donnant un point de départ plus proche du point optimal de convergence de l'algorithme.

La figure 2 illustre une partie d'une chaîne d'émission de signal radio induisant un retard selon un mode de réalisation de la présente invention.

S(t+1) est le signal d'entrée dans le module de pré-distorsion 10.

$S_w(t+1)$ est le signal de sortie du module de pré-distorsion 10, ce signal étant issu de l'application du coefficient de pré-distorsion au signal d'entrée S(t+1).

Il est ici supposé que l'amplificateur de puissance et les autres éléments de la chaîne d'émission induisent un retard 30 par rapport au signal d'origine, ce retard, T, étant supposé connu. Le signal d'entrée, ou encore signal de référence, S(t+1), est donc retardé de ce retard T.

L'erreur quadratique que l'on cherche à réduire, ou minimiser, vérifie l'équation suivante, dans le cas où l'amplificateur de puissance et la chaîne de transmission n'induisent pas de retard :

$$e^2 = \left\| e(t+1) \right\|^2 = \left\| S(t+1) - D_w(t+1) \right\|^2$$

L'application d'un algorithme de gradient stochastique peut alors fournir les équations suivantes, dans le cas où l'amplificateur de puissance et la chaîne de transmission n'induisent pas de retard :

$$C(t+1) = C(t) + \mu_c \cdot e(t+1) \cdot \left( \frac{D_w(t+1)}{W(t)} \right)^{\bullet}$$

$$E(t+1) = E(t) + \mu_c \cdot e(t+1) \cdot \left( \frac{D_w(t+1)}{W(t)} \right)^{\bullet} \cdot a(t+1)$$

et

$$W(t+1) = C(t) + E(t) \cdot a(t+1)$$

où

$$e(t+1) = S(t+1) - D_w(t+1) \ ;$$

où $\mu_c$ et $\mu_e$ correspondent aux pas du gradient respectivement pour les paramètres C(t) et E(t).

Dans le cas où l'amplificateur de Puissance et la chaîne émission créent un retard $\tau$ sur le signal transmis, l'erreur quadratique que l'on cherche à réduire, ou minimiser, vérifie l'équation suivante :

$$e^2 = \left\| e(t+1) \right\|^2 = \left\| S(t+1-\tau) - D_w(t+1) \right\|^2$$

Les équations obtenues par application de l'algorithme du gradient stochastique peuvent alors s'écrire sous la forme suivante :

$$C(t+1) = C(t) + \mu_c.e(t+1).\left(\frac{D_w(t+1)}{W(t)}\right)^{\bullet}$$

$$E(t+1) = E(t) + \mu_c.e(t+1).\left(\frac{D_w(t+1)}{W(t)}\right)^{\bullet}.a(t+1)$$

$$W(t+1) = C(t) + E(t).a(t+1)$$

où

$$e(t+1) = S(t+1-\tau) - D_w(t+1)$$

Par ailleurs, on peut avantageusement prévoir d'appliquer les principes de la présente invention à des signaux modulés dont la composante de modulation varie de façon plus importante.

Ce cas peut notamment se présenter dans le contexte des modulations multi-porteuses pour lesquelles la distribution statistique du signal à transmettre est presque gaussienne, ou encore dans le contexte de modulations à enveloppe fortement non constante comme par exemple les modulations de type QAM (Quadrature Amplitude modulation en anglais), ou de type TT/4 DQPSK (TT/4 Differential Quaternary Phase shift Keying) qui sont utilisées par exemple dans le système de radiocommunications professionnelles TETRA (pour 'TErrestrial Trunked RAdio').

Dans ce contexte, il est prévu de mettre en oeuvre un mode de réalisation de la présente invention, en divisant le signal que l'on veut transmettre en différentes classes de signal, chaque classe de signal correspondant à une plage de variation limitée autour d'une valeur moyenne de l'amplitude dans ladite classe.

Ainsi, on définit les plages de variation correspondant à ces différentes classes, en s'assurant que, au sein de chacune de ces classes, l'hypothèse de faible variation autour de la valeur moyenne de l'amplitude de cette classe est respectée. Puis, on applique l'enseignement décrit ci-avant pour un signal présentant de faibles variations à chacune des classes définies pour un signal présentant des variations plus importantes.

On peut ainsi obtenir, pour chacune de ces classes, les paramètres $C(t)$ et $E(t)$ tels que décrits ci-avant pour un signal présentant de faibles variations.

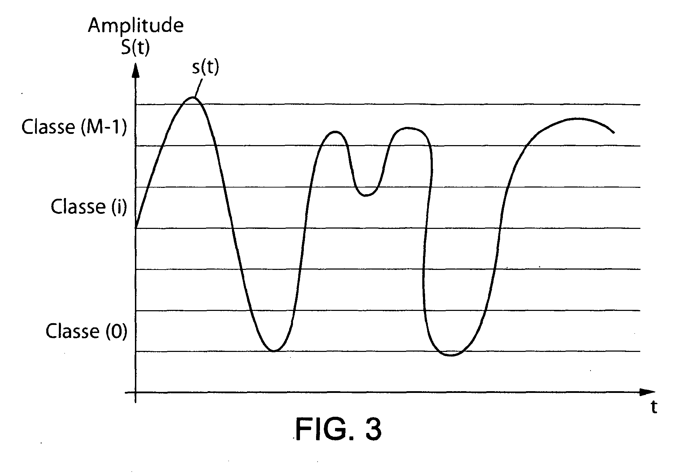

La figure 3 illustre les variations du signal $S(t)$ en fonction du temps $t$, sur lequel sont définies des classes 0 à M-1 par bande d'amplitudes, ou encore par classe, permettant ainsi d'appliquer l'enseignement décrit ci-avant sur un signal $S(t)$ présentant des variations d'amplitude plus importantes.

Dans un mode de réalisation de la présente invention, on peut également prévoir de forcer le paramètre $C(t)$ à la valeur 1. Il est toutefois préférable de forcer ce paramètre de pré-distorsion à cette valeur 1 uniquement pour la classe dont la puissance moyenne des signaux tombant dans ladite classe est la plus proche de la puissance moyenne du signal que l'on souhaite transmettre. Puis, les paramètres $C(t)$ des autres classes ainsi que les paramètres $E(t)$ de l'ensemble des classes sont alors calculés selon l'une des méthodes possibles telles que décrites précédemment, notamment selon un algorithme du gradient stochastique.

**Revendications**

1. Procédé de traitement d'un signal dans une chaîne d'émission comprenant :

   - un amplificateur de puissance (13) adapté pour recevoir en entrée un signal à amplifier $S_w(t)$ (15) et adapté pour fournir en sortie un signal amplifié $D_w(t)$ (16) ;
   - un module de pré-distorsion (10) comprenant, d'une part, une unité de linéarisation (11) adaptée pour appliquer un coefficient de pré-distorsion $W(t)$ à un signal d'entrée $S(t)$ (14), et, d'autre part, une unité de détermination (12) dudit coefficient de pré-distorsion ;

   ledit procédé de traitement comprenant les étapes suivantes mises en oeuvre au niveau du module de pré-distorsion :

/a/ au niveau de l'unité de détermination de coefficient de pré-distorsion, recevoir, d'une part, le signal d'entrée S(t) (14) et, d'autre part, le signal amplifié D$_w$(t) à travers une voie de retour, et déterminer le coefficient de pré-distorsion à partir d'une comparaison entre le signal d'entrée S(t) (14) et le signal amplifié D$_w$(t) (16) ;

/b/ au niveau de l'unité de linéarisation, appliquer le coefficient de pré-distorsion W(t) au signal d'entrée S(t) (14), pour fournir en sortie le signal à amplifier D$_w$(t) (15) ;

dans lequel le coefficient de pré-distorsion W(t) est déterminé, à l'étape /a/, sur la base d'une approximation au premier ordre du signal d'entrée (14).

2. Procédé de traitement selon la revendication 1, dans lequel le signal d'entrée (14) vérifie l'équation suivante selon l'approximation au premier ordre :

$$S(t) = A.(1 + a(t)).e^{j.\varphi(t)},$$

où A représente l'amplitude moyenne du signal, a(t) représente la variation relative de l'amplitude du signal, j représente la racine carrée de -1 ; et φ(t) la phase du signal ; et dans lequel le coefficient de pré-distorsion W(t) vérifie l'équation suivante :

$$W(t) = C(t) + E(t).a(t)$$

où C(t) et E(t) correspondent à des premier et second paramètres de pré-distorsion qui sont des fonctions complexes du temps.

3. Procédé de traitement selon la revendication 2, dans lequel le paramètre de pré-distorsion C(t) est fixé à la valeur 1.

4. Procédé de traitement selon la revendication 2 ou 3, dans lequel au moins un parmi les premier et second paramètres de pré-distorsion est déterminé par application d'un algorithme de gradient stochastique.

5. Procédé de traitement selon la revendication 4, dans lequel le paramètre de pré-distorsion E(t) vérifie l'équation suivante :

$$E(t+1) = E(t) + \mu_e.e(t+1).\left(\frac{D_w(t+1)}{W(t)}\right)^{\bullet}.a(t+1)$$

où D$_w$(t+1) correspond au signal amplifié par l'amplificateur de puissance et reçu au niveau de l'unité de détermination via la voie de retour ;

où e(t+1)=S(t+1)-D$_w$(t+1) ;

où μ$_e$ est le pas du gradient pour le paramètre de pré-distorsion E(t) ; et le coefficient de pré-distorsion vérifie l'équation suivante :

$$W(t+1) = C(t) + E(t).a(t+1)$$

6. Procédé de traitement selon la revendication 4, dans lequel, le signal d'entrée S(t) (14) et le signal amplifié D$_w$(t) (16) étant décalés d'un retard τ, le paramètre de pré-distorsion E(t) vérifie l'équation suivante :

$$E(t+1) = E(t) + \mu_e.e(t+1).\left(\frac{D_w(t+1)}{W(t)}\right)^{\bullet}.a(t+1)$$

où $D_w(t+1)$ correspond au signal amplifié par l'amplificateur de puissance et reçu au niveau de l'unité de détermination via la voie de retour ;

où $e(t+1)=S(t+1-\tau)-D_w(t+1)$;

où $\mu_e$ est le pas du gradient pour le paramètre de pré-distorsion E(t) ; et le coefficient de pré-distorsion vérifie l'équation suivante :

$$W(t+1) = C(t) + E(t).a(t+1)$$

**7.** Procédé de traitement selon la revendication 5 ou 6, dans lequel en outre le paramètre de pré-distorsion C(t) vérifie l'équation suivante :

$$C(t+1) = C(t) + \mu_c.e(t+1).\left(\frac{D_w(t+1)}{W(t)}\right)^*$$

où $D_w(t+1)$ correspond au signal amplifié par l'amplificateur de puissance et reçu au niveau de l'unité de détermination via la voie de retour ; et

où W(t) correspond au coefficient de pré-distorsion ;

et où $\mu_c$ est le pas de l'algorithme du gradient pour le paramètre de pré-distorsion C(t).

**8.** Procédé de traitement selon l'une quelconque des revendications précédentes, dans lequel le signal à amplifier est organisé sous forme de trames et le coefficient de pré-distorsion est mis à jour à chaque N trame(s), N étant un entier supérieur ou égal à 1.

**9.** Procédé de traitement selon l'une quelconque des revendications précédents dans lequel, avant l'étape /a/, une phase d'initialisation au cours de laquelle au moins un coefficient de pré-distorsion initial est déterminé.

**10.** Procédé de traitement selon l'une quelconque des revendications précédentes, dans lequel le signal d'entrée S(t) (14) est décomposé en une pluralité de portions de signal d'entrée, chaque portion de signal d'entrée appartenant à différentes plages d'amplitudes, et
dans lequel on obtient une pluralité de coefficients de pré-distorsion $W_i(t)$, pour i allant de 1 à N, N étant un entier strictement supérieur à 1, respectivement pour la pluralité de portions de signal d'entrée, par application des étapes /a/ et /b/ à chacune desdites portions de signal d'entrée, sur la base d'une approximation au premier ordre de ladite portion de signal d'entrée.

**11.** Chaîne d'émission d'un signal comprenant :

- un amplificateur de puissance (13) adapté pour recevoir en entrée un signal à amplifier (15) et pour fournir en sortie un signal amplifié (16) ;
- un module de pré-distorsion (10) comprenant, d'une part, une unité de linéarisation (11) adaptée pour appliquer un coefficient de pré-distorsion à un signal d'entrée (14), et, d'autre part, une unité de détermination (12) dudit coefficient de pré-distorsion ;

dans laquelle l'unité de détermination de coefficient de pré-distorsion est adaptée pour recevoir, d'une part, le signal d'entrée (14) et, d'autre part, le signal amplifié à travers une voie de retour, et pour déterminer le coefficient de pré-distorsion à partir d'une comparaison entre le signal d'entrée (14) et le signal amplifié (16) sur la base d'une approximation au premier ordre du signal d'entrée (14) ; et,
dans laquelle l'unité de linéarisation est adaptée pour recevoir le signal d'entrée (14), et appliquer le coefficient de pré-distorsion pour fournir en sortie le signal à amplifier (15).

**12.** Chaîne d'émission d'un signal selon la revendication 11, comprenant des moyens adaptés pour mettre en oeuvre un procédé de traitement d'un signal selon l'une quelconque des revendications 2 à 10.

**Claims**

1. Method of processing a signal in a transmission chain comprising:

- a power amplifier (13) adapted for receiving as input a signal to be amplified $S_w$(t) (15) and adapted for providing as output an amplified signal $D_w$(t) (16);
- a predistortion module (10) comprising, on the one hand, a linearization unit (11) adapted for applying a predistortion coefficient W(t) to an input signal S(t) (14), and, on the other hand, a unit (12) for determining said predistortion coefficient;

said processing method comprising the following steps implemented at the level of the predistortion module:

/a/ at the level of the unit for determining the predistortion coefficient, receiving, on the one hand, the input signal S(t) (14) and, on the other hand, the amplified signal $D_w$(t) through a return pathway, and determining the predistortion coefficient on the basis of a comparison between the input signal S(t) (14) and the amplified signal $D_w$(t) (16);

/b/ at the level of the linearization unit, applying the predistortion coefficient W(t) to the input signal S(t) (14), so as to provide as output the signal to be amplified $D_w$(t) (15);

in which the predistortion coefficient W(t) is determined, in step /a/, on the basis of a first-order approximation of the input signal (14).

2. Processing method according to Claim 1, in which the input signal (14) satisfies the following equation according to the first-order approximation:

$$S(t) = A.(1 + a(t)).e^{j \cdot \varphi(t)} \,,$$

where A represents the mean amplitude of the signal, a(t) represents the relative variation of the amplitude of the signal, j represents the square root of -1; and $\varphi$(t) the phase of the signal; and in which the predistortion coefficient W(t) satisfies the following equation:

$$W(t) = C(t) + E(t).a(t)$$

where C(t) and E(t) correspond to first and second predistortion parameters which are complex functions of time.

3. Processing method according to Claim 2, in which the predistortion parameter C(t) is fixed to the value 1.

4. Processing method according to Claim 2 or 3, in which at least one out of the first and second predistortion parameters is determined by applying a stochastic gradient algorithm.

5. Processing method according to Claim 4, in which the predistortion parameter E(t) satisfies the following equation:

$$E(t+1) = E(t) + \mu_e.e(t+1).\left( \frac{D_w(t+1)}{W(t)} \right)^{*}.a(t+1)$$

where $D_w$(t+1) corresponds to the signal amplified by the power amplifier and received at the level of the determining unit via the return pathway;
where $e(t+1) = S(t+1) - D_w(t+1)$;
where $\mu_e$ is the step size of the gradient for the predistortion parameter E(t); and

the predistortion coefficient satisfies the following equation:

$$W(t+1) = C(t) + E(t).a(t+1)$$

6. Processing method according to Claim 4, in which, the input signal S(t) (14) and the amplified signal $D_w$(t) (16) being shifted by a delay $\tau$, the predistortion parameter E(t) satisfies the following equation:

$$E(t+1) = E(t) + \mu_e .e(t+1).\left( \frac{D_w(t+1)}{W(t)} \right)^* .a(t+1)$$

where $D_w$(t+1) corresponds to the signal amplified by the power amplifier and received at the level of the determining unit via the return pathway;
where $e(t+1)=S(t+1-\tau)-D_w(t+1)$;
where $\mu_e$ is the step size of the gradient for the predistortion parameter E(t); and

the predistortion coefficient satisfies the following equation:

$$W(t+1) = C(t) + E(t).a(t+1)$$

7. Processing method according to Claim 5 or 6, in which moreover the predistortion parameter C(t) satisfies the following equation:

$$C(t+1) = C(t) + \mu_c .e(t+1).\left( \frac{D_w(t+1)}{W(t)} \right)^*$$

where $D_w$(t+1) corresponds to the signal amplified by the power amplifier and received at the level of the determining unit via the return pathway; and
where W(t) corresponds to the predistortion coefficient;

and where $\mu_c$ is the step size of the gradient algorithm for the predistortion parameter C(t).

8. Processing method according to any one of the preceding claims, in which the signal to be amplified is organized in the form of frames and the predistortion coefficient is updated at each N frame(s), N being an integer greater than or equal to 1.

9. Processing method according to any one of the preceding claims, in which, before step /a/, an initialization phase in the course of which at least one initial predistortion coefficient is determined.

10. Processing method according to any one of the preceding claims, in which the input signal S(t) (14) is decomposed into a plurality of portions of input signal, each portion of input signal belonging to various amplitude spans, and in which a plurality of predistortion coefficients $W_i$(t) is obtained, for i going from 1 to N, N being an integer strictly greater than 1, respectively for the plurality of portions of input signal, by applying steps /a/ and /b/ to each of said portions of input signal, on the basis of a first-order approximation of said portion of input signal.

11. Signal transmission chain comprising:

- a power amplifier (13) adapted for receiving as input a signal to be amplified (15) and for providing as output an amplified signal (16);
- a predistortion module (10) comprising, on the one hand, a linearization unit (11) adapted for applying a predistortion coefficient to an input signal (14), and, on the other hand, a unit (12) for determining said predistortion coefficient; in which the unit for determining the predistortion coefficient is adapted for receiving, on the one hand, the input signal (14) and, on the other hand, the amplified signal through a return pathway, and for determining the predistortion coefficient on the basis of a comparison between the input signal (14) and the amplified signal (16) on the basis of a first-order approximation of the input signal (14); and,

in which the linearization unit is adapted for receiving the input signal (14), and applying the predistortion coefficient so as to provide as output the signal to be amplified (15).

**12.** Signal transmission chain according to Claim 11, comprising means adapted for implementing a method for processing a signal according to any one of Claims 2 to 10.

**Patentansprüche**

**1.** Verfahren zur Verarbeitung eines Signals in einer Sendekette, das enthält:

- einen Leistungsverstärker (13), der geeignet ist, am Eingang ein zu verstärkendes Signal $S_w(t)$ (15) zu empfangen, und geeignet ist, am Ausgang ein verstärktes Signal $D_w(t)$ (16) zu liefern;
- ein Vorverzerrungsmodul (10), das einerseits eine Linearisierungseinheit (11), die geeignet ist, einen Vorverzerrungskoeffizient W(t) auf ein Eingangssignal S(t) (14) anzuwenden, und andererseits eine Bestimmungseinheit (12) des Vorverzerrungskoeffizienten enthält;

wobei das Verarbeitungsverfahren die folgenden Schritte enthält, die auf der Ebene des Vorverzerrungsmoduls durchgeführt werden:

/a/ auf der Ebene der Vorverzerrungskoeffizient-Bestimmungseinheit Empfangen, einerseits des Eingangssignals S(t) (14) und andererseits des verstärkten Signals $D_w(t)$ über eine Rückführung und Bestimmen des Vorverzerrungskoeffizienten ausgehend von einem Vergleich zwischen dem Eingangssignal S(t) (14) und dem verstärkten Signal $D_w(t)$ (16);
/b/ auf der Ebene der Linearisierungseinheit Anwenden des Vorverzerrungskoeffizienten W(t) auf das Eingangssignal S(t) (14), um am Ausgang das zu verstärkende Signal $D_w(t)$ (15) zu liefern;

wobei der Vorverzerrungskoeffizient W(t) im Schritt /a/ auf der Basis einer Näherung erster Ordnung des Eingangssignals (14) bestimmt wird.

**2.** Verarbeitungsverfahren nach Anspruch 1, bei dem das Eingangssignal (14) die folgende Gleichung gemäß der Näherung erster Ordnung erfüllt:

$$S(t) = A.(1 + a(t)).e^{j.\varphi(t)},$$

wobei A die mittlere Amplitude des Signals darstellt, a(t) die relative Variation der Amplitude des Signals darstellt, j die Quadratwurzel von -1 darstellt; und $\varphi(t)$ die Phase des Signals; und wobei der Vorverzerrungskoeffizient W(t) die folgende Gleichung erfüllt:

$$W(t) = C(t) + E(t).a(t)$$

wobei C(t) und E(t) ersten und zweiten Vorverzerrungsparametern entsprechen, die komplexe Funktionen der Zeit sind.

**3.** Verarbeitungsverfahren nach Anspruch 2, bei dem der Vorverzerrungsparameter C(t) auf den Wert 1 festgelegt wird.

**4.** Verarbeitungsverfahren nach Anspruch 2 oder 3, bei dem mindestens einer der ersten und zweiten Vorverzerrungsparameter durch Anwenden eines stochastischen Gradientenalgorithmus bestimmt wird.

**5.** Verarbeitungsverfahren nach Anspruch 4, bei dem der Vorverzerrungsparameter E(t) die folgende Gleichung erfüllt:

$$E(t+1) = E(t) + \mu_c.e(t+1)\left(\frac{D_w(t+1)}{W(t)}\right)^{\cdot}.a(t+1)$$

wobei $D_w$(t+1) dem Signal entspricht, das vom Leistungsverstärker verstärkt und auf der Ebene der Bestimmungseinheit über die Rückführung empfangen wird;

wobei e(t+1)=S(t+1)-$D_w$(t+1);

wobei $\mu_e$ die Steigung des Gradienten für den Vorverzerrungsparameter E(t) ist; und der Vorverzerrungskoeffizient die folgende Gleichung erfüllt:

$$E(t+1) = E(t) + \mu_c.e(t+1)\left(\frac{D_w(t+1)}{W(t)}\right)^{\cdot}.a(t+1)$$

6.  Verarbeitungsverfahren nach Anspruch 4, bei dem, wenn das Eingangssignal S (t) (14) und das verstärkte Signal $D_w$(t) (16) um eine Verzögerung τ versetzt sind, der Vorverzerrungsparameter E(t) die folgende Gleichung erfüllt:

$$E(t+1) = E(t) + \mu_c.e(t+1)\left(\frac{D_w(t+1)}{W(t)}\right)^{\cdot}.a(t+1)$$

wobei $D_w$(t+1) dem durch den Leistungsverstärker verstärkten und auf der Ebene der Bestimmungseinheit über die Rückführung empfangenen Signal entspricht;

wobei e(t+1)=S(t+1-τ)-$D_w$(t+1);

wobei $\mu_e$ die Steigung des Gradienten für den Vorverzerrungsparameter E(t) ist; und der Vorverzerrungskoeffizient die folgende Gleichung erfüllt:

$$W(t+1) = C(t) + E(t).a(t+1)$$

7.  Verarbeitungsverfahren nach Anspruch 5 oder 6, bei dem außerdem der Vorverzerrungsparameter C(t) die folgende Gleichung erfüllt:

$$C(t+1) = C(t) + \mu_c.e(t+1).\left(\frac{D_w(t+1)}{W(t)}\right)^{\cdot}$$

wobei $D_w$(t+1) dem durch den Leistungsverstärker verstärkten und auf der Ebene der Bestimmungseinheit über die Rückführung empfangenen Signal entspricht; und wobei W(t) dem Vorverzerrungskoeffizient entspricht; und wobei $\mu_c$ die Steigung des Algorithmus des Gradienten für den Vorverzerrungsparameter C(t) ist.

8.  Verarbeitungsverfahren nach einem der vorhergehenden Ansprüche, bei dem das zu verstärkende Signal in Form von Raster strukturiert ist und der Vorverzerrungskoeffizient in jedem N-ten Raster aktualisiert wird, wobei N eine ganze Zahl höher als oder gleich 1 ist.

9.  Verarbeitungsverfahren nach einem der vorhergehenden Ansprüche, bei dem vor dem Schritt /a/ eine Initialisierungsphase durchgeführt wird, während der mindestens ein Anfangs-Vorverzerrungskoeffizient bestimmt wird.

10. Verarbeitungsverfahren nach einem der vorhergehenden Ansprüche, bei dem das Eingangssignal S(t) (14) in mehrere Eingangssignalabschnitte zerlegt wird, wobei jeder Eingangssignalabschnitt zu verschiedenen Amplitudenbereichen gehört, und wobei mehrere Vorverzerrungskoeffizienten $W_i(t)$ für i von 1 bis N jeweils für die mehreren Eingangssignalabschnitte durch Anwenden der Schritte /a/ und /b/ auf jeden der Eingangssignalabschnitte auf der Basis einer Näherung erster Ordnung des Eingangssignalabschnitts erhalten werden, wobei N eine ganze Zahl strikt größer als 1 ist.

11. Sendekette eines Signals, die enthält:

   - einen Leistungsverstärker (13), der geeignet ist, am Eingang ein zu verstärkendes Signal (15) zu empfangen und am Ausgang ein verstärktes Signal (16) zu liefern;
   - ein Vorverzerrungsmodul (10), das einerseits eine Linearisierungseinheit (11), die geeignet ist, einen Vorverzerrungskoeffizient auf ein Eingangssignal (14) anzuwenden, und andererseits eine Bestimmungseinheit (12) des Vorverzerrungskoeffizienten enthält;

   wobei die Bestimmungseinheit des Vorverzerrungskoeffizienten geeignet ist, um einerseits das Eingangssignal (14) und andererseits das verstärkte Signal über eine Rückführung zu empfangen, und den Vorverzerrungskoeffizient ausgehend von einem Vergleich zwischen dem Eingangssignal (14) und dem verstärkten Signal (16) auf der Basis einer Näherung erster Ordnung des Eingangssignals (14) zu bestimmen; und
   wobei die Linearisierungseinheit geeignet ist, das Eingangssignal (14) zu empfangen und den Vorverzerrungskoeffizient anzuwenden, um am Ausgang das zu verstärkende Signal (15) zu liefern.

12. Sendekette eines Signals nach Anspruch 11, die Mittel enthält, welche geeignet sind, ein Verfahren zur Verarbeitung eines Signals nach einem der Ansprüche 2 bis 10 durchzuführen.

S(t) ——14——•——101—→ **Linéarisation** (11) ——15——→ $S_w(t)$

14 ——→ **Déterm. coeff.** (12) ←——102——←16——

10 · 103

PA (13)

16 →↓ $D_w(t)$

## FIG. 1

S(t+1) ——101——•——→ **Linéarisation** (11) ——103——→ $S_w(t+1)$

τ (30)

S(t+1-τ) ——→ **W(t)** (12) ←——102——←16——

PA (13)

10

16 →↓ $D_w(t+1)$

## FIG. 2

FIG. 3